# EUROPEAN PATENT APPLICATION

(11) **EP 2 763 302 A1**
(43) Date of publication of application: **06.08.2014**
(21) Application number: 11873203.1
(22) Date of filing: 26.09.2011
(51) Int. Cl.: H02M 7/06

(54) **RECTIFIER OF ALTERNATING-CURRENT GENERATOR FOR VEHICLE**

(71) Applicant: Mitsubishi Electric Corporation, Tokyo 100-8310 (JP)
(72) Inventor: IMAGAWA Seisaku, Tokyo 100-8310 (JP)
(74) Representative: HOFFMANN EITLE
(86) International application number: PCT/JP2011/071821
(87) International publication number: WO 2013/046289

(57) **Abstract**

In a rectifier device (2) for full-wave rectifying an output of a vehicle alternating-current generator (1), a schottky barrier diode having a characteristic whose forward voltage drop with respect to a forward current is small and whose reverse leakage current is small, is used as a rectifier semiconductor element(201),(202) constituting the rectifier device(2).

## Description

### TECHNICAL FIELD

This invention relates to rectifier devices of alternating-current generators for on-vehicle use, and in particular, to rectifier devices of vehicle alternating-current generators in which schottky barrier diodes are used as semiconductor devices constituting the rectifier devices.

### BACKGROUND ART

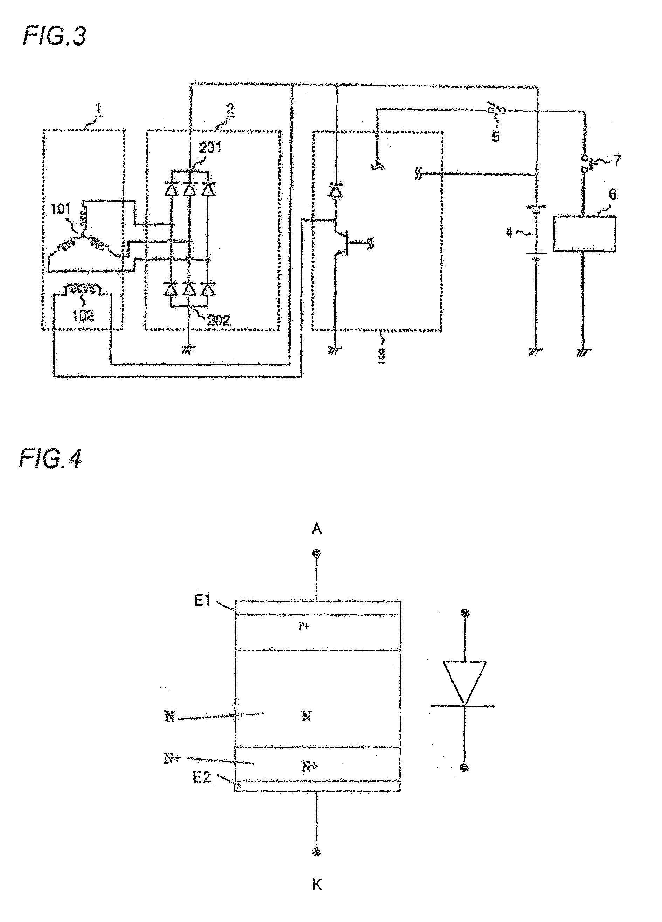

Fig.3 is a circuit configuration diagram for showing an example of conventional rectifier device of a vehicle alternating-current generator.

The conventional rectifier device with a vehicle alternating-current generator is configured with: an alternating-current generator 1 comprising a field coil 102 that is activated by a not shown vehicle engine (engine machine) to generate a rotating magnetic field, and armature windings 101 that generates and outputs an AC voltage by the generated rotating magnetic field; a rectifier 2 that rectifies a generated voltage of the alternating- current generator 1 to supply it from a main terminal to a battery 4 or an electric load 6; a voltage regulator 3 that controls an excitation current for the field coil 102 according to a terminal voltage of the battery 4 or the electric load 6 to thereby regulate the generated voltage of the alternating-current generator 1; a load switch 7 for connecting the generated voltage of the alternating current generator 1 to the electric load 6; and a key-switch 5 that allows the excitation current to flow from the battery 4 though the voltage regulator 3 to the field coil 102 when the engine machine is started.

Fig.4 shows a structure of a PN junction diode in such a conventional device, which is a silicon diode given as each of semiconductor rectifier elements 201,202 that are used in the rectifier 2.

As shown in Fig.4, the PN junction diode is configured by joining together a P-type semiconductor and an N-type semiconductor which are made of silicon, followed by forming an electrode E1 on the P-type semiconductor to establish an anode terminal A and forming an electrode E2 on the N-type semiconductor to establish a cathode terminal K.

In such a PN junction diode, there is a large forward voltage drop with respect to a forward current, thereby suppressing rise in output voltage to cause a limit for its output current.

In addition, since a PN junction diode has a large forward voltage drop with respect to a forward current and therefore, generates large heat due to power loss, there is also a problem that the temperature of the armature windings 101 of the alternating-current generator becomes higher, so that the output current is suppressed.

Thus, as another conventional rectifier device, there is proposed a device which is configured to reduce power loss of the vehicle alternating-current generator and to decrease a heat generation amount thereof, by using, as the semiconductor rectifier element, a schottky barrier diode made of silicon carbide in place of such a PN junction diode (see Patent Document 1, for example).

### CITATION LIST

### PATENT DOCUMENTS

Patent Document 1: International Patent Application Publication No. WO 1999/036966

### SUMMARY OF THE INVENTION

### PROBLEMS TO BE SOLVED BY THE INVENTION

However, in the conventional device disclosed in Patent Document 1, although the voltage drop with respect to a forward current becomes smaller than that of the PN junction diode thereby making it possible to suppress heat generation due to the power loss, the reverse leakage current is larger than that of the PN junction diode. Thus, when a conventional schottky barrier diode is applied to the rectifier of a vehicle alternating-current generator, a problem arises in that there are risks of occurrence of thermal runaway due to heat generation of the diode under high temperature, false operation of the voltage regulator, and battery run-out during stopping of the engine (engine machine).

This invention has been made to solve the problem as described above, and an object thereof is to provide a rectifier device of a vehicle alternating-current generator which can reduce power loss in comparison to that with the PN junction diode to thereby raise the output current upward, and which can suppress the reverse leakage current up to the same level as that with the PN junction diode to thereby eliminate risks of occurrence of thermal runaway due to heat generation of the diode under high temperature, false operation of the voltage regulator, and battery run-out during stopping of the engine (engine machine).

### MEANS FOR SOLVING THE PROBLEMS

The rectifier device of a vehicle alternating-current generator according to the invention is a rectifier device that performs full-wave rectification of an output of the vehicle alternating-current generator, wherein, as a rectifier semiconductor element constituting the rectifier device, a diode is used which has a characteristic whose forward voltage drop with respect to a forward current is small and whose reverse leakage current is small.

Further, in the rectifier device, as the diode, a schottky barrier diode having a junction barrier schottky structure is used so as to suppress the reverse leakage current.

### EFFECT OF THE INVENTION

According to the rectifier device of a vehicle alternating-current generator, since the schottky barrier diode is used in place of a PN junction diode, the forward voltage drop is made small to thereby reduce power loss and raise the output current upward, and also, heat generation due to the power loss is decreased, so that the temperature of the armature windings of the alternating-current generator becomes low thereby increasing the output current.

Further, since the reverse leakage current is suppressed up to the same level as that with the PN junction diode by applying a junction barrier schottky structure to the schottky barrier diode, there is provided an effect that eliminates risks of occurrence of thermal runaway due to heat generation of the diode under high temperature, false operation of the voltage regulator, and battery run-out during stopping of the engine (engine machine) .

The foregoing and other objects, features and advantages of the present invention will become more apparent from the following detailed description of the embodiment and the accompanying drawings.

### BRIEF DESCRIPTION OF THE DRAWINGS

Fig.1 is a circuit diagram of a rectifier device of a vehicle alternating-current generator, according to Embodiment 1 of the invention.
Fig.2 is a cross-sectional view showing a structure of a schottky barrier diode used in the rectifier device according to Embodiment 1 of the invention.
Fig.3 is a circuit diagram for showing an example of conventional rectifier device of a vehicle alternating-current generator.
Fig.4 is a cross-sectional view showing a structure of a PN junction diode used in the conventional rectifier device.

### MODES FOR CARRYING OUT THE INVENTION

### Embodiment 1

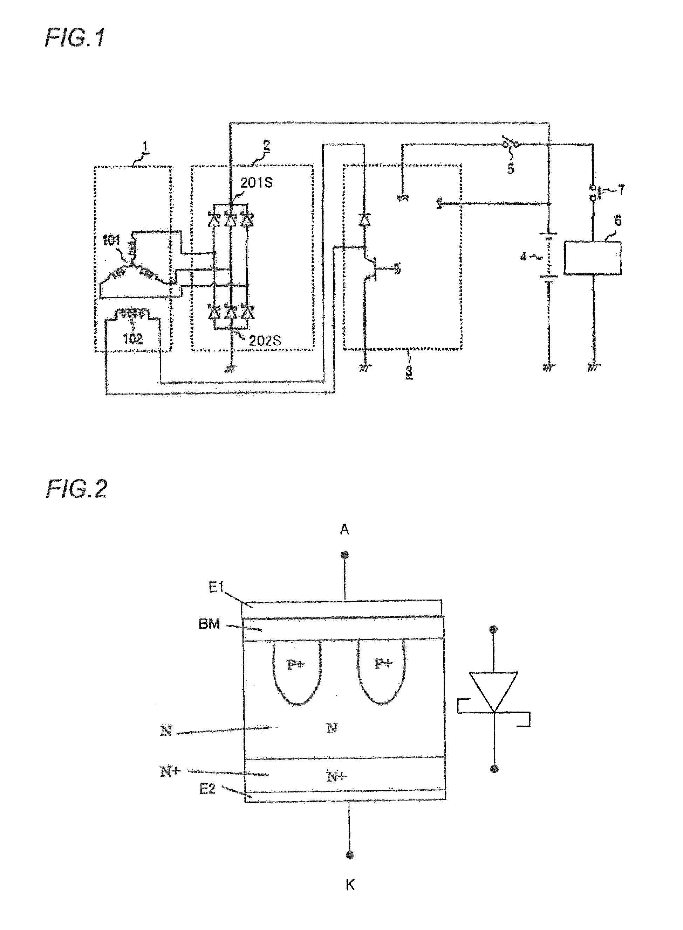

Fig.1 is a circuit diagram for showing a rectifier device of a vehicle alternating-current generator, according to Embodiment 1 of the invention. What is the structural difference of Embodiment 1 from the conventional device illustrated in Fig.3 is that, in place of the PN-junction diodes 241, 202, diodes 201S, 202S which have a characteristic whose forward voltage drop with respect to a forward current is smaller than that of the PN junction diodes, and whose reverse leakage current is the same level as that of the PN junction diodes, are used as semiconductor elements of the rectifier 2. Thus, the other structures are similar to those in Fig.3.

That is, in Fig.1, the rectifier device with a vehicle alternating-current generator is configured with: an alternating-current generator 1 comprising a field coil 102 that is activated by a not shown vehicle engine (engine machine) to generate a rotating magnetic field, and armature windings 101 that generates and outputs an AC voltage by the generated rotating magnetic field; a rectifier 2 comprising rectifier semiconductor elements 201S, 202S that rectifies the generated voltage of the alternating-current generator 1 to supply it from a main terminal to a battery 4 or an electric load 6; a voltage regulator 3 that controls an excitation current for the field coil 102 according to a terminal voltage of the battery 4 or the electric load 6 to thereby regulate the generated voltage of the alternating-current generator 1; a load switch 7 for connecting the generated voltage of the alternating current generator 1 to the electric load 6; and a key-switch 5 that allows the excitation current to flow from the battery 4 though the voltage regulator 3 to the field coil 102 when the engine machine is started.

Fig.2 is a cross-sectional view showing the structure of the schottky barrier diodes 201S, 202S as the rectifier semiconductor elements for constituting the rectifier 2 in Embodiment 1.

In Fig.2, the schottky barrier diode is configured with a barrier metal BM and a N-type semiconductor N which are joined together. Further, an anode terminal A is formed on the barrier metal BM through an electrode E1, and a cathode terminal K is formed on the N-type semiconductor through an electrode E2.

In general, a schottky barrier diode operates with many carriers and thus has a characteristic whose forward voltage drop is smaller that that of a PN-junction diode. However, on the other side, a schottky barrier diode has a characteristic whose leakage current at the interface between the schottky electrode and the semiconductor becomes larger than that of a PN-junction diode when a voltage is applied in backward direction, because of the difference in work function between a metal for the electrode material and the semiconductor.

Thus, in Embodiment 1 of the invention, in order to suppress the reverse leakage current of a schottky barrier diode, such a schottky barrier diode is used as the diode for constituting the rectifier 2, which has a junction barrier schottky structure that is configured by forming a plurality of P-type semiconductor regions under the schottky barrier electrode BM constituting the schottky barrier diode so that PN junction portions are formed inside the schottky barrier diode.

In the schottky barrier diode having the thus-configured junction barrier schottky structure, the depletion layer extends from the PN junction region when inversely biased, to thereby mitigate the electric field of the schottky junction region, so that the reverse leakage current can be decreased.

As described above, the rectifier device for a vehicle alternating-current generator of Embodiment 1 of the invention, uses a schottky barrier diode having a junction barrier schottky structure, as the rectifier semiconductor element constituting the rectifier device.

Consequently, according to the rectifier device for a vehicle alternating-current generator of Embodiment 1 of the invention, since the forward voltage drop of the schottky barrier diode with respect to the forward current is smaller than that of a PN junction diode, it becomes possible to make the output voltage higher, thereby raising the output current upward.

In addition, since the forward voltage drop is smaller than that of a PN junction diode and accordingly the heat generation becomes smaller, there is provided an effect that the temperature of the armature windings of the alternating-current generator becomes lower to thereby increase the output current.

Further, since the schottky barrier diode as in the rectifier device according to Embodiment 1 has a junction barrier schottky structure so that the reverse leakage current is suppressed up to the same level as that of the PN junction diode, it becomes possible to eliminate problems of occurrence of thermal runaway due to heat generation of the diode under high temperature, false operation of the voltage regulator, and battery run-out during stopping of the engine (engine machine).

### INDUSTRIAL APPLICABILITY

This invention is suitably applied to a rectifier device of an alternating-current generator to be mounted on a vehicle.

### DESCRIPTION OF REFERENCE NUMERALS AND SIGNS

1: alternating-current generator, 2: rectifier, 3: voltage regulator, 4: battery, 5: key switch, 6: electric load, 7: load switch, 201,202: rectifier semiconductor elements (schottky barrier diodes), BM: barrier metal (schottky electrode), N: N-type semiconductor, E1, E2: electrodes, A: anode terminal, K: cathode terminal.

## Claims

1. A rectifier device of a vehicle alternating-current generator that performs full-wave rectification of an output of the vehicle alternating-current generator, wherein, as a rectifier semiconductor element constituting the rectifier device, a diode is used which has a characteristic whose forward voltage drop with respect to a forward current is smaller than that of a PN junction diode, and whose reverse leakage current is as small as the same level as that of the PN junction diode.

2. The rectifier device of a vehicle alternating-current generator of Claim 1, wherein, as the diode, a schottky barrier diode having a junction barrier schottky structure is used so as to suppress the reverse leakage current.

3. The rectifier device of a vehicle alternating-current generator of Claim 2, wherein the junction barrier schottky structure includes a plurality of P-type semiconductor regions formed under a schottky electrode, so that PN junction portions are formed inside the schottky barrier diode.
